# EUROPEAN PATENT SPECIFICATION

(11) **EP 0 354 765 B1**
(45) Date of publication and mention of the grant of the patent: **10.12.1997**
(21) Application number: 89308057.2
(22) Date of filing: 08.08.1989
(51) Int. Cl.: H01L 29/732, H01L 21/331, H01L 29/10

(54) **Process for fabricating a bipolar transistor**
Verfahren zur Herstellung eines Bipolartransistors
Procédé de fabrication d'un transistor bipolaire

(30) Priority: 12.08.1988 JP 201360/88
(43) Date of publication of application: 14.02.1990
(73) Proprietor: SONY CORPORATION, Tokyo 141 (JP)
(72) Inventor: Gomi, Takayuki c/o Patents Division Sony Corp., Shinagawa-ku Tokyo 141 (JP)
(74) Representative: Cotter, Ivan John

(56) References cited:
- EP-A- 0 029 548
- EP-A- 0 096 155
- EP-A- 0 255 882
- FR-A- 2 396 411
- US-A- 4 066 473

## Description

This invention relates to a process for fabricating high operating speed type bipolar transistors.

To produce a high speed high performance bipolar transistor, it is necessary to reduce the base width WB, while it is also important to reduce the base resistance Rbb. To this end we have proposed forming a linking base region between an intrinsic base region as an active region and a graft base region which is produced by diffusing impurities from the base contact electrode. This is disclosed, for example, in JP-A-1 28959, 1 31460 and 1 31461, published after the priority date of the present invention.

In linking the intrinsic base region and the graft base region by the linking base region of the same conductivity type, damage is caused when the linking base region is formed by ion implantation, giving rise to accelerated diffusion into the active region and to adverse effects due to so-called channelling tail. Among these adverse effects is an increase in the base junction depth caused in the ensuing heat treatment. As described in JP-A-1 28959 there is also known a method comprising forming side walls on the lateral sides of the base contact electrode, and utilising these side walls to remove the substrate partially to form an emitter region and a base region of extremely small size and, above all, extremely shallow depth. However, the side injection effect of the emitter and the base interfere with the high speed operation.

For overcoming this inconvenience, we have proposed in JP-A-1208864, published after the priority date of the present invention, a technique in which a diffusion suppressing or restraining region having opposite conductivity type to that of the base region is provided below the intrinsic base region.

However, for further improving the performance of the bipolar transistor, it is necessary to prevent the width of, for example, the linking base region functioning as a parasitic base region from being increased, to suppress the side injection effect more completely.

European Published Patent Application EP-A-0096155 discloses a process for fabricating bipolar transistors using a sidewall technique.

French Published Patent Application FR-A-2396411 discloses a bipolar transistor having a linking base region.

European Published Patent Application EP-A-0255882 discloses a bipolar transistor having a diffusion suppressing region.

According to the present invention there is provided a process for fabricating a bipolar transistor, the process comprising the following successive steps:
providing a semiconductor substrate of a first conductivity type having a surface;
forming a semiconductor layer of a second conductivity type in said semiconductor substrate and exposed at said surface thereof;
forming an epitaxial layer of said second conductivity type on said surface of the semiconductor substrate above said semiconductor layer which is thereby buried;
selectively oxidising said epitaxial layer thereby forming a field oxide layer said field oxide layer surrounding a portion of said epitaxial layer, said portion of said epitaxial layer forming a device forming region having a top surface;
forming a base contact electrode layer on top of said device forming region, said base contact electrode layer containing impurities of said first conductivity type and being covered by an insulating layer;
removing a portion of said base contact electrode layer covered by said insulating layer thereby forming an opening above said device forming region;
introducing into said device forming region in said epitaxial layer via said opening to respective predetermined depths, by ion implantation, impurities forming on annealing a linking base region of said first conductivity type and a diffusion suppressing region of said second conductivity type, said linking base region being located on said diffusion suppressing region;
diffusing said impurities from said base contact electrode layer into said device forming region by heat treatment thereby forming a graft base region of said first conductivity type to a deeper depth than the depth of said linking base region;
forming sidewall spacers on the side walls of said opening in said base contact electrode layer, said sidewall spacers having an exposed surface and said linking base region being linked at the bottom side of the sidewall spacers with said graft base region in a partially overlapping relation therewith;
forming a thin polysilicon layer on said top surface of said device forming region and along said exposed surface of said sidewall spacers, said thin polysilicon layer containing impurities,
forming an intrinsic base region of said first conductivity type linked at the bottom of said sidewall spacers with said linking base region in a partially overlapping relation therewith, in an offset relation with said graft base region, and to a deeper depth than the depth of said linking base region by diffusing impurities contained in said thin polysilicon layer from said thin polysilicon layer into said device forming region, using said sidewall spacers as a mask thereby limiting lateral spreading of said intrinsic base region, said intrinsic base region being located on said diffusion suppressing region and said diffusion suppressing region limiting downward spreading of said intrinsic base region;
forming an emitter region of said second conductivity type in said intrinsic base region by diffusing impurities contained in said thin polysilicon layer from said thin polysilicon layer into said intrinsic base region.

In a bipolar transistor fabricated according to the present invention, a base region is formed in a collector region. The base region comprises a graft base region, a linking base region and an intrinsic base region. An emitter region is formed within the intrinsic base region. A diffusion restraining region is formed under at least the intrinsic base region by introducing impurities having the opposite conductivity type to that of the impurities forming the base region. This diffusion restraining region is extended to the lower portion of the linking base region. The linking base region provides for electrical connection between the intrinsic base region and the graft base region. To prevent the effective base width from being increased, and also to prevent the characteristics from being deteriorated due to the side injection effects, the linking base region is so formed that its diffusion depth is shallower than that of the intrinsic base region.

The invention will now be described by way of example with reference to the accompanying drawings, throughout which like parts are referred to by like references, and in which:
Figure 1 is a sectional view of a bipolar transistor;
Figure 2 is a sectional view of parts of the bipolar transistor;
Figure 3 is a sectional view showing another bipolar transistor;
Figures 4 to 6 are diagrams showing the impurity concentration distribution on the cross sections along the lines IV-IV, V-V and VI-VI, respectively, of Figure 3; and
Figures 7a to 7d are cross-sectional views illustrating a method of producing a bipolar transistor in accordance with the present invention.

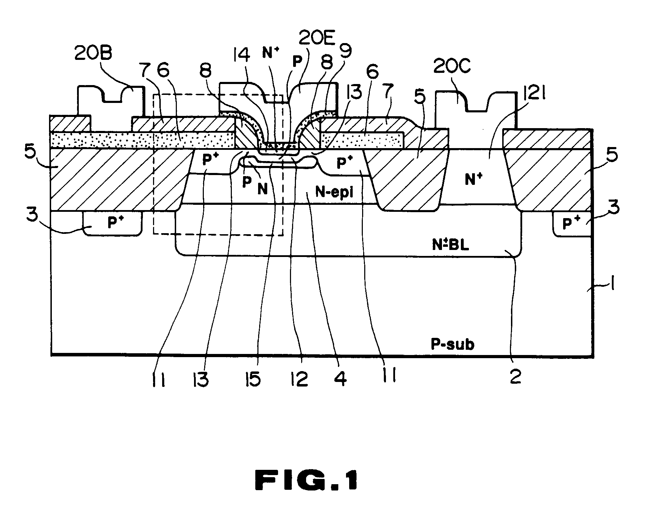

Referring to Figure 1, the bipolar transistor comprises an N⁺ type buried layer 2 and a P⁺ type channel stop region 3 formed on a P type silicon substrate 1, an N type epitaxial layer 4 being formed thereabove. A field oxide film 5 for device isolation is formed adjacent to the epitaxial layer 4. The field oxide film 5 is a film of silicon dioxide formed by a selective oxidation process. A polysilicon layer 6 covered by an interlayer insulating film 7 is formed on a portion of the upper surface of the epitaxial layer 4 surrounded by the field oxide film 5. The polysilicon layer 6 contains impurities and is used as a base contact electrode. The polysilicon layer 6 also functions as the diffusion source of impurities of a P⁺ type graft base region 11 formed in the epitaxial layer 4. Sidewall sections 8 are formed by etching back a chemical vapour deposition (CVD) oxide film on the side wall of an opening formed in a portion of the polysilicon layer 6 on the epitaxial layer 4. The sidewall sections 8 provide for emitter-base isolation, while a polysilicon layer 9 as the second layer may be utilised to form an intrinsic base region and an emitter region in a self-aligned manner. The thin polysilicon layer 9 is applied to the upper surfaces of the sidewall sections 8 and the epitaxial layer 4, and an emitter electrode 20E is formed thereabove by patterning an aluminium base interconnecting layer.

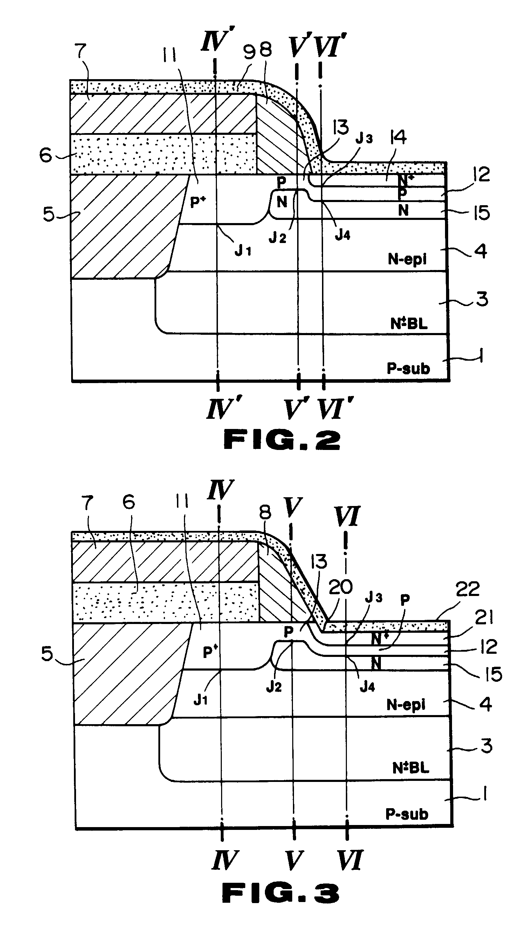

The epitaxial layer 4 at the opened portion will now be explained with reference to Figure 2. The P⁺ type graft base region 11 is formed by diffusion from the surface of the polysilicon layer 6 in contact with the epitaxial layer 4. The graft base region 11 is linked via a P type linking base region 13 with an intrinsic base region 12, which is the P⁺ type impurity diffused region. The linking base region 13 is formed from the vicinity of the end of the polysilicon layer 6 along the major surface of the epitaxial layer 4, and is linked at the bottom side of the sidewall sections 8 with the graft base region 11 in a partially overlapping relation therewith. The depth of a junction J2 of this linking base region 13 is selected to be shallower than the depth of a junction J4 of the intrinsic base region 12, and also than the depth of a junction J1 of the graft base region 11. There is a junction J3 of the emitter region. The intrinsic base region 12 is formed by diffusing impurities from the thin polysilicon layer 9 extending on the sidewall section 8 and above the major surface, and is linked in the active region with the linking base region 13 in a partially overlapping relation therewith. The depth of the junction J4 of the intrinsic base region 12 is selected to be deeper than the depth of the junction J2 of the linking base region 13, as mentioned above. Within the intrinsic base region 12, and in the epitaxial layer 4 below the polysilicon layer 9, is formed an emitter region 14 which is the N⁺ type semiconductor region. The emitter region 14 is formed by, for example, diffusing impurities from the polysilicon layer 9. Below the intrinsic base region 12 and the linking base region 13 is formed a diffusion suppressing or restraining region 15 for preventing the depth of these impurity diffused regions from being increased further. That is, impurities of the opposite conductivity type to that of the intrinsic base region 12 and the linking base region 13 are introduced below the intrinsic base region 12 and the linking base region 13 to maintain the N conductivity type in the region, such that occasionally diffused impurities from the regions 12 and 13 are compensated by the opposite N conductivity type, to prevent the depth of the junction from being increased further.

Returning to Figure 1, the buried layer 2 is linked via a collector contact region 121 to a collector electrode 20c. On the other hand, the polysilicon layer 6, which is the base contact electrode, is linked with a base electrode 20B formed via a portion of the interlayer insulating film 7. The collector electrode 20C and the base electrode 20B are respectively formed by patterning an aluminium base interconnecting layer.

Figure 3 shows a modified bipolar transistor. In this embodiment the sidewall sections 8 are formed by RIE and, for removing the damage caused by RIE, the surface of the epitaxial layer 4 is etched, with the sidewall sections 8 and the interlayer insulating film 7 as a mask, for forming a step 20 on the surface of the epitaxial layer 4. A thin polysilicon layer 22 for diffusion is formed over the surface of the step 20, and an emitter region 21 is formed on the surface of the epitaxial layer 4. The step 20 is effective to remove the damage caused by RIE and to produce a shallow junction, thanks also to the aforementioned diffusion restraining region 15. The side injection effect can also be suppressed since the depth of the junction J2 of the linking base region 13 is shallower than the depth of the junction J4 of the intrinsic base region 12.

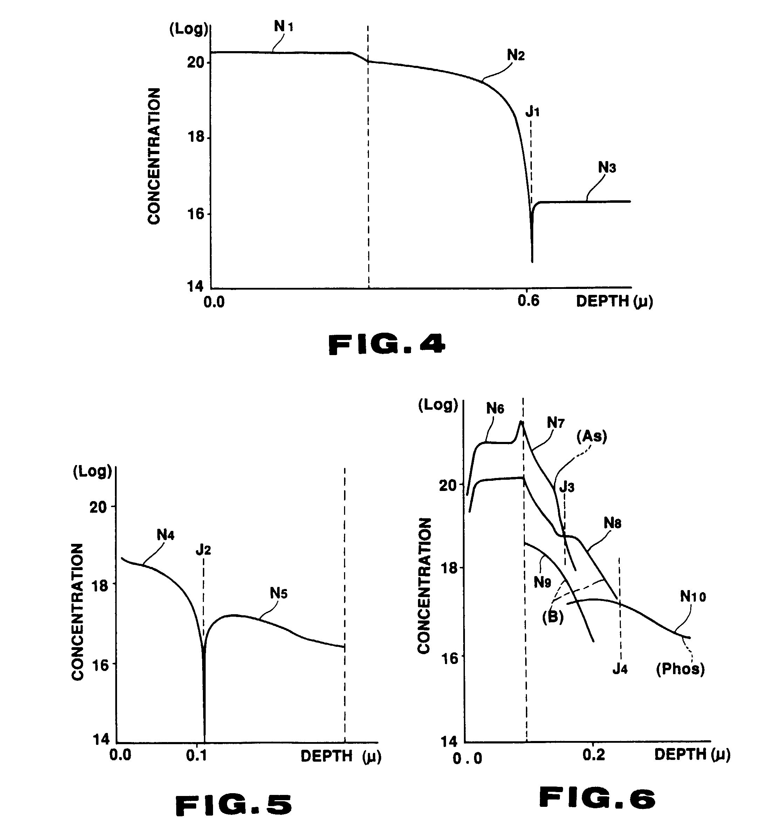

In Figures 4 to 6, the ordinate represents the impurity concentration, shown by a logarithmic scale, and the abscissa represents the depth in µm. It is noted that the distribution of impurity concentration shown in Figures 4 to 6 is roughly coincident with that on the cross-sections along lines IV'-IV', V'-V' and VI'-VI' of Figure 2.

In Figure 4, the distribution of the impurity concentration above the surface of the epitaxial layer 4 corresponds to the impurity concentration N1 of the polysilicon layer 6. Since the graft base region 11 is formed by diffusing impurities from the polysilicon layer 6, the impurity concentration N2 is about equal in the vicinity of the graft base region 11 to the impurity concentration N1 and becomes gradually low as the depth of the junction J1 is approached. This junction depth is about, for example, 3110 x 10⁻¹⁰m. From the depth of the junction J1 on, there prevails the impurity concentration N3 of the N type epitaxial layer 4.

In Figure 5, from the surface of the epitaxial layer 4 on, there exists the linking base region 13, which is the P type impurity diffused layer, the impurity concentration N4 of which is lowered gradually towards the depth of the junction J2. This junction depth is about, for example, 1100 x 10⁻¹⁰m. The region therebelow is the epitaxial layer 4 where there prevails the N type impurity concentration N5. The distribution of the impurity concentration N5 is such that a mild peak exists at a deeper zone of the depth of the junction J2. Since this zone functions as the diffusion restraining region 15, it becomes unnecessary to increase the depth of the junction J2 such as by heat treatment.

In Figure 6, the impurity concentration above the surface of the epitaxial layer 4 is the impurity concentration N6 of the thin polysilicon layer 9. The impurity concentration has a peak on the surface of the epitaxial layer 4, and shifts to the impurity concentration N7 of the emitter region 21 directly below the surface of the epitaxial layer 4. The impurity concentrations N6 and N7 are that of arsenic (As). The impurity concentration N7 of this emitter region 21 is lowered gradually towards the depth of the junction J3. From the depth of the junction J3 and as far as the depth of the junction J4, the impurity concentration N8 of the intrinsic base region 12 prevails. The concentration N8 is the impurity concentration of boron (B). Meanwhile, the distribution of the impurity concentration N9 represents the overlapped distribution into the intrinsic base region 12 and into the emitter region 21 of boron forming the linking base region 13. The impurity concentration N10 of the epitaxial layer 4 prevails at the depth of the junction J4 of the intrinsic base region 12. The impurity concentration N10 is that of phosphorus (P) and exhibits a mild peak at the depth of the junction J4 for forming the diffusion restraining region 15. Considering the depth of the junction from the distribution of these impurities, a peak of phosphorous having the opposite conductivity type to that of the intrinsic base region 12 exists in the vicinity of the depth of the junction J4. Therefore, even supposing that boron, the impurity of the intrinsic base region 12, is diffused in the depthwise direction, the function of the impurity concentration N10 prevailing in the diffusion restraining region 15 is effective to prevent the depth of the junction J4 from being increased disadvantageously, so improving the performance of the bipolar transistor. The depth of the junction J4 is about 1500 x 10⁻¹⁰m from the surface, while the depth of the junction J2 of the linking base region 13 is about 1100 x 10⁻¹⁰m, and as shown in Figure 5, the depth of the junction J4 is deeper than that of the junction J2. Hence, the effective base width of the parasitic base region becomes narrower, so suppressing the side injection effect.

In the above-described bipolar transistor, the depth of the junction can be prevented from being increased by the function of the diffusion suppressing region 15. In this manner, the base width WB may be prevented from being increased, so that it becomes possible to increase the operating speed of the device. As described above, the depth of the junction J4 of the intrinsic base region 12 is selected to be deeper than the depth of the junction J2 of the linking base region 13. As a result, the effective base width of the parasitic base region is reduced to suppress the effect of side injection.

In this bipolar transistor, the concentration of impurities introduced for forming the diffusion suppressing region 15 may be selected to be higher than the impurity concentration in the N type epitaxial layer 4 to suppress the Kirk effect. Also a low consumption type bipolar transistor or a high speed bipolar transistor can be selectively produced by controlling the values of the impurity concentration. The bipolar transistor may be of the PNP type in lieu of the NPN type of the above-described transistors.

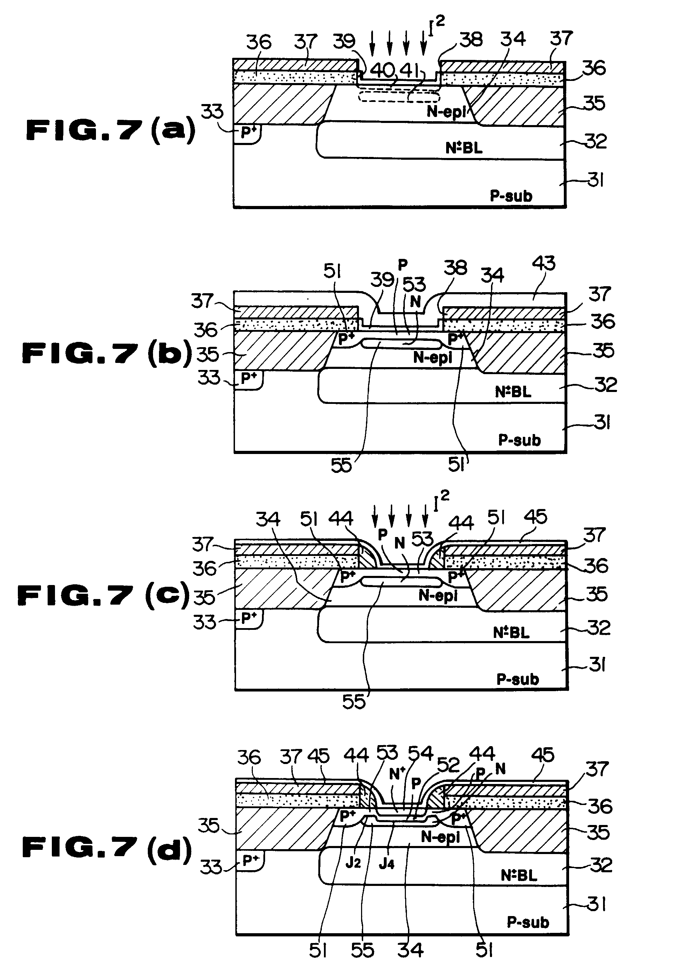

Referring to Figures 7a to 7d, in accordance with the present invention, a process for producing the above-described bipolar transistor will be explained in the sequence of the production steps thereof.

First, as shown in Figure 7a, an N type buried layer 32 is formed on a P type single crystal silicon substrate 31. The N type buried layer 32 is selectively formed for linking with the collector contact region. An epitaxial layer 34 is then formed on the P type silicon substrate 31. A field oxide film 35, functioning as the device isolation region, is formed on the epitaxial layer 34 by selective oxidation. A channel stop region 33 for device isolation is formed on the bottom of the field oxide film 35, while the surface of the field oxide film 35 is flattened. On the top of the epitaxial layer 34 surrounded two-dimensionally by the field oxide film 35 is formed a polysilicon layer 36 containing P type impurities. The P type impurities may include B⁺ or BF₂⁺. The polysilicon layer 36 is roughly patterned to the profile of the base contact electrode, and then covered by an interlayer insulating film 37. The polysilicon layer 36 and the interlayer insulating film 37 are selectively formed for facing the major surface of the epitaxial layer 34, and are opened partially to form an opening 38, on which a thin oxide film 39 used as a buffer film is formed to a film thickness, for example, of 150 x 10⁻¹⁰m.

After formation of the oxide film 39, the linking base region is formed by ion implantation. Dopants used for this ion implantation may include, for example, B⁺ and BF₂⁺, and are implanted into a region 40 in the vicinity of the major surface of the epitaxial layer 34 so as not to increase the depth of the linking base region. It will be noted that the impurities are not introduced into the zone below the polysilicon layer 36 since the layer 36, above all, functions as the mask.

Then, ion implantation is performed at the same opening 38 for forming the diffusion suppressing region through the oxidation film 39. This ion implantation is performed with the use of impurities such as P⁺ or As⁺ in such a manner that the impurities are implanted into a region 41 which is deeper than the region where the linking base region or the intrinsic base region is to be formed. The Kirk effect can be suppressed by positively increasing the concentration of the impurities used for ion implantation. Also a low consumption type bipolar transistor or a high speed type bipolar transistor can be selectively produced by controlling the concentration of the impurities used in the ion implantation.

A thick oxide film 43 is then formed on the overall surface by, for example, CVD. The opening 38 having the thin oxide film 39 on the bottom thereof is similarly covered by the thick oxide film 43.

Then, as shown in Figure 7B, the impurities are diffused by heat treatment from the polysilicon layer 36 which is to be the aforementioned base contact electrode, for forming a graft base region 51. On annealing, the impurities implanted into the region 40 form a linking base region 53 in the vicinity of the major surface of the epitaxial layer 34 on the bottom of the opening 38. Similarly, the impurities implanted into the region 41 form a diffusion suppressing region 55 on annealing below the linking base region 53.

The thick oxide film 43, that also functioned as the anneal cap, is then etched back and caused to remain on the sidewall of the opening 38 as sidewall sections 44. The oxide film 39 within the opening 38 is simultaneously removed.

For producing a bipolar transistor having a step 20, as shown in Figure 3, it suffices to perform etching of silicon after the etching back process to remove a surface portion of the epitaxial layer 34.

A thin polysilicon layer 45 is then formed on the overall surface. The polysilicon layer 45 is extended from the upper surface of the interlayer insulating film 37 over the sidewall section 44 and from the sidewall section 44 over the major surface where the epitaxial layer 34 is formed.

Then, as shown in Figure 7c, ion implantation is performed on the overall surface. By this ion implantation, there are introduced impurities into the thin polysilicon layer 45. These impurities, which may for example be B⁺ or BF₂⁺, form the intrinsic base region 52 on the major surface of the epitaxial layer 34. It will be noted that, since the sidewall section 44 functions as the mask for ion implantation and diffusion of impurities, the linking base region 53 is caused to remain below the sidewall section 44. In the region facing to the opening between the sidewall sections 44, the intrinsic base region 52 is formed by the subsequent annealing in an offset relation with respect to the graft base region 51 and in an overlapping relation with respect to the linking base region 53.

Annealing is then performed for forming the intrinsic base region 52. During this annealing, the silicon oxide film is capped. The intrinsic base region 52 is formed by diffusing impurities from the polysilicon layer 45 so as to have the depth of the junction J4 deeper than the depth of the junction J2 of the linking base region 53. The base width WB of the intrinsic base region 52 is also prevented from being increased due to the previously formed diffusion suppressing region 55 below the intrinsic base region 52.

The silicon oxide film on the surface is then removed, and ion implantation is again performed into the polysilicon layer 45. By the impurities used for this ion implantation, which may, for example, be As⁺, an emitter region 54 is formed. This formation is achieved by diffusion from the polysilicon layer 45 on heat treatment to produce the bipolar transistor as shown in Figure 7d.

By the above-described sequence of operations, the bipolar transistor is obtained which is provided with the diffusion suppressing region 55, as described above. In this bipolar transistor, a low base resistance Rbb' is realised by the linking base region, while simultaneously the adverse effects such as deterioration in voltage withstand properties of the emitter-base junction, VBE matching properties or in the value of fT, are suppressed. The process of forming the linking base region 53 is separate from that of forming the intrinsic base region 52, so that the relation of the depth of the junction J4 of the intrinsic base region 52 being larger than the depth of the junction J2 of the linking base region 52 is obtained by proper control of the duration, impurity concentration and temperature of the respective processes. As a result, the side injection effect is restricted. On the other hand, the base width WB is prevented from being increased due to the function of the diffusion suppressing region 55, whereas, subject to proper control of the impurity concentration thereof, the Kerk effect can be suppressed, or a lower power consumption device or a high speed device can be produced.

## Claims

1. A process for fabricating a bipolar transistor, the process comprising the following successive steps:
providing a semiconductor substrate (31) of a first conductivity type having a surface;
forming a semiconductor layer (32) of a second conductivity type in said semiconductor substrate (31) and exposed at said surface thereof;
forming an epitaxial layer (34) of said second conductivity type on said surface of the semiconductor substrate (31) above said semiconductor layer (32) which is thereby buried;
selectively oxidising said epitaxial layer (34) thereby forming a field oxide layer (35) said field oxide layer (35) surrounding a portion of said epitaxial layer (34), said portion of said epitaxial layer (34) forming a device forming region having a top surface;
forming a base contact electrode layer (36) on top of said device forming region, said base contact electrode layer (36) containing impurities of said first conductivity type and being covered by an insulating layer (37);
removing a portion of said base contact electrode layer (36) covered by said insulating layer (37) thereby forming an opening (38) above said device forming region;
introducing into said device forming region in said epitaxial layer (34) via said opening to respective predetermined depths, by ion implantation, impurities forming on annealing a linking base region (53) of said first conductivity type and a diffusion suppressing region (55) of said second conductivity type, said linking base region (53) being located on said diffusion suppressing region (55);
diffusing said impurities from said base contact electrode layer (36) into said device forming region by heat treatment thereby forming a graft base region (51) of said first conductivity type to a deeper depth than the depth of said linking base region (53);
forming sidewall spacers (44) on the side walls of said opening in said base contact electrode layer (36), said sidewall spacers (44) having an exposed surface and said linking base region (53) being linked at the bottom side of the sidewall spacers (44) with said graft base region (51) in a partially overlapping relation therewith;
forming a thin polysilicon layer (45) on said top surface of said device forming region and along said exposed surface of said sidewall spacers (44), said thin polysilicon layer (36) containing impurities,
forming an intrinsic base region (52) of said first conductivity type linked at the bottom of said sidewall spacers (44) with said linking base region (53) in a partially overlapping relation therewith, in an offset relation with said graft base region (51), and to a deeper depth than the depth of said linking base region (53) by diffusing impurities contained in said thin polysilicon layer (45) from said thin polysilicon layer (45) into said device forming region, using said sidewall spacers (44) as a mask thereby limiting lateral spreading of said intrinsic base region (52), said intrinsic base region (52) being located on said diffusion suppressing region (55) and said diffusion suppressing region (55) limiting downward spreading of said intrinsic base region (52);
forming an emitter region (54) of said second conductivity type in said intrinsic base region (52) by diffusing impurities contained in said thin polysilicon layer from said thin polysilicon layer (45) into said intrinsic base region (52).

2. A process according to claim 1 wherein, after forming said sidewall spacers (44), the exposed surface portion of said device forming region is removed, thereby forming a step (20), wherein said intrinsic base region (52) is formed in said device forming region provided with said step (20).

## Patentansprüche

1. Verfahren zur Herstellung eines Bipolartransistors, wobei das Verfahren die folgenden aufeinanderfolgenden Schritte umfaßt:
Bereitstellen eines Halbleitersubstrats (31) einer ersten Leitfähigkeit, welches eine Fläche hat;
Bilden einer Halbleiterschicht (32) einer zweiten Leitfähigkeit auf dem Halbleitersubstrat (31), welche auf ihrer Fläche unverdeckt ist;
Bilden einer Epitaxialschicht (34) der zweiten Leitfähigkeit auf der Fläche des Halbleitersubstrats (31) über der Halbleiterschicht (32), die dadurch eingegraben wird;
Selektives Oxidieren der Epitaxialschicht (34), wodurch eine Bereichsoxidschicht (35) gebildet wird, wobei die Bereichsoxidschicht (35) einen Bereich der Epitaxialschicht (34) umgibt, wobei der Bereich der Epitaxialschicht (34) eine Einrichtung, die einen Bereich bildet, bildet, der eine Kopffläche hat;
Bilden einer Basiskontaktelektrodenschicht (36) auf dem Kopf der Einrichtung, die den Bereich bildet, wobei die Basiskontaktelektrodenschicht (36) Verunreinigungen der ersten Leitfähigkeit enthält und durch eine Isolationsschicht (37) bedeckt ist;
Entfernen eines Bereichs der Basiskontaktelektrodenschicht (36), die durch die Isolationsschicht (37) bedeckt ist, um dadurch eine Öffnung (38) über der Einrichtung, die den Bereich bildet, zu bilden;
Einbringen von Verunreinigungen in die Einrichtung, die den Bereich bildet, in die Epitaxialschicht (34) über die Öffnung in entsprechende vorgegebene Tiefen durch Ionenimplantation, um beim Tempern einen Verbindungsbasisbereich (53) der ersten Leitfähigkeit und einen Diffusionsunterdrückungsbereich (55) der zweiten Leitfähigkeit zu bilden, wobei der Verbindungsbasisbereich (53) auf dem Diffusionsunterdrückungsbereich (55) angeordnet ist;
Diffundieren der Verunreinigungen von der Basiskontaktelektrodenschicht (36) in die Einrichtung, die den Bereich bildet, durch Wärmebehandlung, wodurch ein Transplantationsbasisbereich (51) der ersten Leitfähigkeit bis zu einer tieferen Tiefe als die Tiefe des Verbindungsbasisbereichs (53) gebildet wird;
Bilden von Seitenwandtrennstücken (44) auf den Seitenwänden der Öffnung in der Basiskontaktelektrodenschicht (36), wobei die Seitenwandtrennstücke (44) eine unverdeckte Fläche haben und der Verbindungsbasisbereich (53) am Boden der Seitenwandtrennstücke (44) mit dem Transplantationsbasisbereich (51) teilweise überlappend damit verbunden ist;
Bilden einer dünnen Polysiliziumschicht (45) auf der Kopffläche der Einrichtung, die den Bereich bildet, und längs der unverdeckten Fläche der Seitenwandtrennstücke (44), wobei die dünne Polysiliziumschicht (36) Verunreinigungen enthält;
Bilden eines Eigenleitungsbasisbereichs der ersten Leitfähigkeit, der am Boden der Seitenwandtrennstücke (44) mit dem Verbindungsbasisbereich (53) in einer versetzten Lage zum Transplantationsbasisbereich (51) teilweise überlappend damit verbunden ist, und bis zu einer tieferen Tiefe als die Tiefe des Verbindungsbasisbereichs (53) durch Diffundieren von Verunreinigungen, die in der dünnen Polysiliziumschicht (45) enthalten sind, aus der dünnen Polysiliziumschicht (45) in die Einrichtung, die den Bereich bildet, wobei die Seitenwandtrennstücke (44) als Maske verwendet werden, um dadurch ein seitliches Ausbreiten des Eigenleitungsbasisbereichs (52) zu begrenzen, wobei der Eigenleitungsbasisbereich (52) auf dem Diffusionsunterdrückungsbereich (55) angeordnet ist und der Diffusionsunterdrückungsbereich (55) ein Abwärts-Ausbreiten des Eigenleitungsbasisbereichs (52) begrenzt;
Bilden eines Emitterbereichs (54) der zweiten Leitfähigkeit im Eigenleitungsbasisbereich (52) durch Diffundieren von Verunreinigungen, die in der dünnen Polysiliziumschicht (45) enthalten sind, von der dünnen Polysiliziumschicht (45) in den Eigenleitungsbasisbereich (52).

2. Verfahren nach Anspruch 1, wobei nach dem Bilden der Seitenwandtrennstücke (44) der unverdeckte Flächenbereich der Einrichtung, die den Bereich bildet, entfernt wird, wodurch ein Absatz (20) gebildet wird, wobei der Eigenleitungsbasisbereich (52) in der Einrichtung, die den Bereich bildet, der mit dem Absatz (20) versehen ist, gebildet wird.

## Revendications

1. Procédé de fabrication d'un transistor bipolaire comportant les étapes successives suivantes:
apport d'un substrat semiconducteur (31) d'un premier type de conductivité présentant une surface;
formation d'une couche semiconductrice (32) d'un second type de conductivité dans ledit substrat semiconducteur (31) et mise à nu sur ladite surface de celui-ci;
formation d'une couche épitaxiale (34) dudit second type de conductivité sur ladite surface du substrat semiconducteur (31) au-dessus de ladite couche semiconductrice (32) qui se trouve ainsi enterrée;
oxydation sélective de ladite couche épitaxiale (34), en formant ainsi une couche d'oxyde de champ (35), ladite couche d'oxyde de champ (35) entourant une partie de ladite couche épitaxiale (34), ladite partie de ladite couche épitaxiale (34) formant une région de formation de dispositif présentant une surface supérieure;
formation d'une couche d'électrode de contact de base (36) au-dessus de ladite région de formation du dispositif, ladite couche d'électrode de contact de base (36) contenant des impuretés dudit premier type de conductivité et étant recouverte d'une couche isolante (37);
élimination d'une partie de ladite couche d'électrode de base (36) recouverte par ladite couche d'isolement (37), formant ainsi une ouverture (38) au-dessus de ladite région de formation du dispositif;
introduction dans ladite région formant le dispositif dans ladite couche épitaxiale (34), par l'intermédiaire de ladite ouverture, à des profondeurs respectives prédéterminées, par implantation ionique, d'impuretés formant par recuit une région de base de liaison (53) dudit premier type de conductivité et une région de suppression de diffusion (55) dudit second type de conductivité, ladite région de base de liaison (53) étant située sur ladite région de suppression de diffusion (55);
diffusion desdites impuretés depuis ladite couche d'électrode de contact de base (36) dans ladite région de formation du dispositif par traitement thermique, en formant ainsi une région de base greffée (51) dudit premier type de conductivité à une profondeur plus importante que la profondeur de ladite région de base de liaison (53);
formation d'entretoises de paroi latérale (44) sur les parois latérales de ladite ouverture dans ladite couche d'électrode de contact de base (36), lesdites entretoises de paroi latérale (44) ayant une surface à nu et ladite région de base de liaison (53) étant reliée sur le côté inférieur des entretoises de paroi latérale (44) à ladite région de base greffée (51) en recouvrement partiel avec celle-ci;
formation d'une couche mince de silicium polycristallin (45) sur ladite surface supérieure de ladite région de formation du dispositif et le long de ladite surface à nu desdites entretoises de paroi latérale (44), ladite couche mince de silicium polycristallin (36) contenant des impuretés;
formation d'une région de base intrinsèque (52) dudit premier type de conductivité reliée à la base desdites entretoises de paroi latérale (44) à ladite région de base de liaison (53) en recouvrement partiel avec celle-ci, de façon déportée par rapport à ladite région de base greffée (51), et à une profondeur plus importante que la profondeur de ladite région de base de liaison (53) en diffusant des impuretés contenues dans ladite couche mince de silicium polycristallin (45) à partir de ladite couche mince de silicium polycristallin (45) dans ladite région de formation du dispositif, en utilisant lesdites entretoises de paroi latérale (44) comme masque, en limitant ainsi un étalement latéral de ladite région de base intrinsèque (52), ladite région de base intrinsèque (52) étant située sur ladite région de suppression de diffusion (55) et ladite région de suppression de diffusion (55) limitant un étalement vers le bas de ladite région de base intrinsèque (52);
formation d'une région d'émetteur (54) dudit second type de conductivité dans ladite région de base intrinsèque (52) en diffusant des impuretés contenues dans ladite couche mince de silicium polycristallin depuis ladite couche mince de silicium polycristallin (45) dans ladite région de base intrinsèque (52).

2. Procédé selon la revendication 1, dans lequel, après formation desdites entretoises de paroi latérale (44), la partie superficielle à nu de ladite région de formation du dispositif est éliminée, en formant ainsi un gradin (20), dans lequel ladite région de base intrinsèque (52) est formée dans ladite région de formation du dispositif munie dudit gradin (20).
